Europäisches Patentamt

European Patent Office

Office européen des brevets

(11) Veröffentlichungsnummer: **0 454 109 A1**

# (12) EUROPÄISCHE PATENTANMELDUNG

(21) Anmeldenummer: 91106664.5

(22) Anmeldetag: 25.04.91

(51) Int. Cl.5: **C11D 7/50**, C11D 7/28, H05K 3/26

(30) Priorität: 26.04.90 DE 4013369

(43) Veröffentlichungstag der Anmeldung:
30.10.91 Patentblatt 91/44

(84) Benannte Vertragsstaaten:
BE DE DK ES FR GB IT NL

(71) Anmelder: HOECHST AKTIENGESELLSCHAFT
Postfach 80 03 20
W-6230 Frankfurt am Main 80(DE)

(72) Erfinder: Robeck, Horst
Berliner Strasse 12
W-6238 Hofheim am Taunus(DE)
Erfinder: Deger, Hans-Matthias, Dr.
Am Rheingauweg 8
W-6238 Hofheim am Taunus(DE)

(54) Neues azeotropes oder azeotropartiges Gemisch aus 2,2,2-Trifluorethyl-1,1,2,2-tetrafluorethylether und Ethanol sowie dessen Verwendung.

(57) Die Erfindung betrifft ein neues azeotropes oder azeotropartiges Gemisch, das im wesentlichen aus etwa 90-97 Masse-% 2,2,2-Trifluorethyl-1,1,2,2-tetrafluorethylether und etwa 3-10 Masse-% Ethanol besteht, sowie ein Verfahren zur Reinigung von elektrischen oder elektronischen Bauteilen, insbesondere gelöteten Leiterplatten oder gedruckten Schaltungen, aber auch anderen festen Oberflächen mit Hilfe dieses Gemisches. Insbesondere Lötflußmittel können mit Hilfe dieses Gemisches von Leiterplatten entfernt werden.

EP 0 454 109 A1

Die Erfindung betrifft ein neues azeotropes oder azeotropartiges Gemisch aus 2,2,2-Trifluorethyl-1,1,2,2-tetrafluorethylether $CF_3CH_2OCF_2CF_2H$ und Ethanol, welches zum Reinigen von elektrischen und elektronischen Bauteilen verwendet werden kann.

Nach Lötvorgängen an elektrischen und elektronischen Bauteilen wird im allgemeinen das überschüssige Lötflußmittel wieder entfernt. Zum Reinigen von gelöteten Leiterplatten und anderen elektronischen Bauteilen werden beispielsweise Gemische aus 1,1,2-Trichlor-1,2,2-trifluorethan (R 113) und Alkoholen wie Methanol, Ethanol oder 2-Propanol verwendet (GB-PS 1 026 003, GB-PS 1 399 867). Aus der US-Patentschrift 3 960 746 ist eine azeotropartige Mischung aus R 113, Methanol und Nitromethan, bekannt. Da jedoch die Fluorchlorkohlenwasserstoffe im Verdacht stehen, die Ozonschicht su schädigen, ist es notwendig, chlorfreie Ersatzstoffe zu entwickeln.

Chlorfreie Ersatzstoffe sind z.B. Lösemittelgemische auf wäßriger Basis oder nicht halogenierte organische Lösemittel. Bei wäßrigen Reinigungsmitteln ist es jedoch schwierig, die richtige Tensid/Komplexbildner-Kombination zu finden. Auch muß das System an die mechanische Behandlung wie Spülen, Bürsten, Dampfstrahlen oder Ultraschall angepaßt werden. Bei der SMT (Surface Mount Technology)-Technik scheiden wäßrige Reinigungssysteme häufig aus, da sich das Wasser unter den Bauteilen nur schwer entfernen läßt. Beim Einsatz nichthalogenierter organischer Lösemittel wie Benzin, Alkohol, Terpenen oder Estern ist aufgrund der Brennbarkeit und der Explosivität dieser Substanzen eine explosionsgeschützte Ausführung der Anlage erforderlich, so daß aus ökonomischen Gründen eine Verwendung nur in bestimmten Fällen in Frage kommt. In der nicht vorveröffentlichten deutschen Patentanmeldung P 40 02 120.3 wird ein azeotropartiges Lösemittelgemisch aus 1,4-Dihydroperfluorbutan und Methanol beschrieben, welches für die Reinigung elektrischer und elektronischer Bauteile geeignet ist.

Überraschenderweise wurde nun gefunden, daß 2,2,2-Trifluorethyl-1,1,2,2-tetrafluorethylether $CF_3CH_2OCF_2CF_2H$ mit Ethanol ein azeotropes oder azeotropartiges Lösemittelgemisch bildet, welches hervorragend zum Reinigen von elektrischen und elektronischen Bauteilen, insbesondere von gelöteten Leiterplatten oder gedruckten Schaltungen vor allem zum Entfernen von Lötflußmitteln geeignet ist.

Ein Gegenstand der Erfindung ist daher ein azeotropes oder azeotropartiges Gemisch, welches im wesentlichen aus einer wirksamen Menge an 2,2,2-Trifluorethyl-1,1,2,2-tetrafluorethylether und Ethanol besteht.

Das Gemisch besteht im wesentlichen im allgemeinen aus 90-97 Masse-% 2,2,2-Trifluorethyl-1,1,2,2-tetrafluorethylether und etwa 3-10 Masse-% Ethanol. Vorzugsweise besteht das Gemisch aus etwa 92-95 Masse-%, insbesondere 93,6-93,8 Masse-% 2,2,2-Trifluorethyl-1,1,2,2-tetrafluorethylether, wobei der Rest jeweils im wesentlichen Ethanol ist.

Ein weiterer Gegenstand der Erfindung ist ein Verfahren zur Reinigung von elektrischen oder elektronischen Bauteilen, insbesondere gelöteten Leiterplatten oder gedruckten Schaltungen, das dadurch gekennzeichnet ist, daß man die Bauteile mit einem azeotropen oder azeotropartigen Gemisch wäscht, das im wesentlichen aus etwa 90-97 Masse-% 2,2,2-Trifluorethyl-1,1,2,2-tetrafluorethylether und etwa 3-10 Masse-% Ethanol besteht. Vorzugsweise verwendet man ein Gemisch, das aus 92-95 Masse-%, insbesondere 93,6-93,8 Masse-% 2,2,2-Trifluorethyl-1,1,2,2-tetrafluorethylether besteht, wobei der Rest jeweils im wesentlichen Ethanol ist.

Ein besonders bevorzugtes Lösemittelgemisch besteht im wesentlichen aus 93,7 Masse-% 2,2,2-Trifluorethyl-1,1,2,2-tetrafluorethylether und 6,3 Masse-% Ethanol und hat einen Siedepunkt von 53,1 °C bei 1 bar.

Bei dem erfindungsgemäßen Gemisch ist die Zusammensetzung des Dampfes identisch oder im wesentlichen identisch mit der Zusammensetzung der Flüssigkeit, d.h. beim Verdampfen ändert sich die Zusammensetzung des Gemisches nicht oder nicht wesentlich.

Das erfindungsgemäße Lösemittelgemisch hat den Vorteil, daß es kein Chlor enthält und damit keine Ozonschädigung bewirkt. Außerdem ist es nicht brennbar und kann in den üblichen Ultraschall-, Tauch- oder Bürstenanlagen zum Reinigen von elektronischen Bauteilen eingesetzt werden. Darüberhinaus sind die Reinigungszeiten von elektronischen Bainteilen mit dem erfindungsgemäßen Gemisch im Vergleich zu herkömmlichen Mitteln bis zu 80 % kürzer. Außerdem lassen sich ionische Rückstände auf den elektronischen Bainteilen besser entfernen als mit den herkömmlichen Gemischen.

2,2,2-Trifluorethyl-1,1,2,2-tetrafluorethylether (CAS No. 406/78/0) kann durch Umsetzung von $CF_3CH_2OH$ mit $F_2C=CF_2$ in Gegenwart einer Base (wie NaOH) in einem Lösungsmittel (wie N-Methylpyrrolidon) hergestellt werden.

Der Reinigungseffekt des neuen Lösemittelgemisches soll beispielhaft an drei ausgewählten Lötflußmitteln gezeigt werden.

**Beispiel 1:**

Ein glasfaserverstärktes Basismaterial für Leiterplatten auf Polyesterbasis wurde mit einem handelsüblichen Lötflußmittel ("Zeva C20-200" der Fa. Zevatron, Hauptbestandteil Kollophonium, daneben Aktivatoren) bestrichen und 18 Stunden bei 60°C im Trockenschrank getrocknet. Anschließend wurde das Material mit einem Gemisch aus 2,2,2-Trifluorethyl-1,1,2,2-tetrafluorethylether (93,7 Masse-%) und Ethanol (6,3 Masse-%) unter Anwendung von Ultraschall gewaschen. Die Einwirkzeit betrug 20 Sekunden. Das Flußmittel war danach vollständig von dem Basismaterial entfernt.

**Beispiel 2:**

Beispiel 2 wurde wie Beispiel 1 durchgeführt, nur daß als Lötflußmittel "Zeva C30-300" der Fa. Zevatron (Hauptbestandteil Kollophonium neben Aktivatoren) verwendet wurde. Nach einer Einwirkzeit von 20 Sekunden war das Flußmittel vollständig entfernt.

**Beispiel 3:**

Beispiel 3 wurde wie Beispiel 1 durchgeführt, nur daß als Lötflußmittel "Flußmittel 100" der Fa. ERSA (Hauptbestandteil Kollophonium, daneben Aktivatoren) verwendet wurde. Nach einer Einwirkzeit von 20 Sekunden war das Flußmittel vollständig entfernt.

**Patentansprüche**

1. Azeotropes oder azeotropartiges Gemisch, welches im wesentlichen aus einer wirksamen Menge an 2,2,2-Trifluorethyl-1,1,2,2-tetrafluorethylether und Ethanol besteht.

2. Azeotropes oder azeotropartiges Gemisch nach Anspruch 1, das im wesentlichen aus etwa 90-97 Masse-% 2,2,2-Trifluorethyl-1,1,2,2-tetrafluorethylether und etwa 3-10 Masse-% Ethanol besteht.

3. Azeotropes oder azeotropartiges Gemisch nach Anspruch 1, das im wesentlichen aus etwa 92-95 Masse-% 2,2,2-Trifluorethyl-1,1,2,2-tetrafluorethylether und etwa 5-8 Masse % Ethanol besteht.

4. Azeotropes oder azeotropartiges Gemisch nach Anspruch 1, das im wesentlichen aus etwa 93,6-93,8 Masse-% 2,2,2-Trifluorethyl-1,1,2,2-tetrafluorethylether und etwa 6,2-6,4 Masse-% Ethanol besteht.

5. Azeotropes oder azeotropartiges Gemisch nach Anspruch 4, das im wesentlichen aus 93,7 Masse-% 2,2,2-Trifluorethyl-1,1,2,2-tetrafluorethylether und 6,3 Masse-% Ethanol besteht und einen Siedepunkt von 53,1°C bei 1 bar hat.

6. Lösungsmittel, welches eine wirksame Menge an 2,2,2-Trifluorethyl-1,1,2,2-tetrafluorethylether und Ethanol enthält.

7. Verfahren zur Reinigung von elektrischen oder elektronischen Bauteilen, insbesondere gelöteten Leiterplatten oder gedruckten Schaltungen, dadurch gekennzeichnet, daß man die Bauteile mit einem azeotropen oder azeotropartigen Gemisch nach einem der Ansprüche 1 bis 5 wäscht.

8. Verfahren zur Entfernung von Lötflußmitteln, gekennzeichnet durch eine Wäsche mit einem azeotropen oder azeotropartigen Gemisch nach einem der Ansprüche 1 bis 5.

9. Verfahren zur Reinigung einer festen Oberfläche, dadurch gekennzeichnet, daß man die feste Oberfläche mit einem azeotropen oder azeotropartigen Gemisch nach einem der Ansprüche 1 bis 5 wäscht.

10. Verwendung eines azeotropen oder azeotropartigen Gemisches nach einem der Ansprüche 1 bis 5 als Lösungsmittel.

**Patentansprüche für folgenden Vertragsstaat: ES**

1. Verfahren zur Reinigung von elektrischen oder elektronischen Bauteilen, insbesondere gelöteten Leiterplatten oder gedruckten Schaltungen, dadurch gekennzeichnet, daß man die Bauteile mit einem azeotropen oder azeotropartigen Gemisch wäscht, welches im wesentlichen aus einer wirksamen Menge an 2,2,2-Trifluorethyl-1,1,2,2-tetrafluorethylether und Ethanol besteht.

2. Verfahren nach Anspruch 1, dadurch gekennzeichnet, daß das azeotrope oder azeotropartige Gemisch im wesentlichen aus etwa 90-97 Masse-% 2,2,2-Trifluorethyl-1,1,2,2-tetrafluorethylether und etwa 3-10 Masse-% Ethanol besteht.

3. Verfahren nach Anspruch 1, dadurch gekennzeichnet, daß das azeotrope oder azeotropartige Gemisch im wesentlichen aus etwa 92-95 Masse-% 2,2,2-Trifluorethyl-1,1,2,2-tetrafluorethylether und etwa 5-8 Masse % Ethanol besteht.

4. Verfahren nach Anspruch 1, dadurch gekennzeichnet, daß das azeotrope oder azeotropartige Gemisch im wesentlichen aus etwa 93,6-93,8 Masse-% 2,2,2-Trifluorethyl-1,1,2,2-tetrafluorethylether und etwa 6,2-6,4 Masse-% Ethanol besteht.

5. Verfahren nach Anspruch 1, dadurch gekennzeichnet, daß das azeotrope oder azeotropartige Gemisch im wesentlichen aus 93,7 Masse-% 2,2,2-Trifluorethyl-1,1,2,2-tetrafluorethylether und 6,3 Masse-% Ethanol besteht und einen Siedepunkt von 53,1 °C bei 1 bar hat.

6. Verfahren zur Reinigung einer festen Oberfläche, dadurch gekennzeichnet, daß man die feste Oberfläche mit einem azeotropen oder azeotropartigen Gemisch wäscht, welches im wesentlichen aus einer wirksamen Menge an 2,2,2-Trifluorethyl-1,1,2,2-tetrafluorethylether und Ethanol besteht.

7. Verfahren nach Anspruch 6, dadurch gekennzeichnet, daß das azeotrope oder azeotropartige Gemisch im wesentlichen aus etwa 90-97 Masse-% 2,2,2-Trifluorethyl-1,1,2,2-tetrafluorethylether und etwa 3-10 Masse-% Ethanol besteht.

8. Verfahren nach Anspruch 6, dadurch gekennzeichnet, daß das azeotrope oder azeotropartige Gemisch im wesentlichen aus etwa 92-95 Masse-% 2,2,2-Trifluorethyl-1,1,2,2-tetrafluorethylether und etwa 5-8 Masse % Ethanol besteht.

9. Verfahren nach Anspruch 6, dadurch gekennzeichnet, daß das azeotrope oder azeotropartige Gemisch im wesentlichen aus etwa 93,6-93,8 Masse-% 2,2,2-Trifluorethyl-1,1,2,2-tetrafluorethylether und etwa 6,2-6,4 Masse-% Ethanol besteht.

10. Verfahren nach Anspruch 6, dadurch gekennzeichnet, daß das azeotrope oder azeotropartige Gemisch im wesentlichen aus 93,7 Masse-% 2,2,2-Trifluorethyl-1,1,2,2-tetrafluorethylether und 6,3 Masse-% Ethanol besteht und einen Siedepunkt von 53,1 °C bei 1 bar hat.

11. Verfahren zur Entfernung von Lötflußmitteln, gekennzeichnet durch eine Wäsche mit einem azeotropen oder azeotropartigen Gemisch, das im wesentlichen aus einer wirksamen Menge an 2,2,2-Trifluorethyl-1,1,2,2-tetrafluorethylether und Ethanol besteht.

12. Verfahren nach Anspruch 11, dadurch gekennzeichnet, daß das azeotrope oder azeotropartige Gemisch im wesentlichen aus etwa 90-97 Masse-% 2,2,2-Trifluorethyl-1,1,2,2-tetrafluorethylether und etwa 3-10 Masse-% Ethanol besteht.

13. Verfahren nach Anspruch 11, dadurch gekennzeichnet, daß das azeotrope oder azeotropartige Gemisch im wesentlichen aus etwa 92-95 Masse-% 2,2,2-Trifluorethyl-1,1,2,2-tetrafluorethylether und etwa 5-8 Masse % Ethanol besteht.

14. Verfahren nach Anspruch 11, dadurch gekennzeichnet, daß das azeotrope oder azeotropartige Gemisch im wesentlichen aus etwa 93,6-93,8 Masse-% 2,2,2-Trifluorethyl-1,1,2,2-tetrafluorethylether und etwa 6,2-6,4 Masse-% Ethanol besteht.

15. Verfahren nach Anspruch 11, dadurch gekennzeichnet, daß das azeotrope oder azeotropartige Gemisch im wesentlichen aus 93,7 Masse-% 2,2,2-Trifluorethyl-1,1,2,2-tetrafluorethylether und 6,3 Masse-% Ethanol besteht und einen Siedepunkt von 53,1 °C bei 1 bar hat.

16. Verwendung eines azeotropen oder azeotropartigen Gemisches, das im wesentlichen aus einer wirksamen Menge an 2,2,2-Trifluorethyl-1,1,2,2-tetrafluorethylether und Ethanol besteht, als Lösungsmittel.

## EINSCHLÄGIGE DOKUMENTE

EP 91106664.5

| Kategorie | Kennzeichnung des Dokuments mit Angabe, soweit erforderlich, der maßgeblichen Teile | Betrifft Anspruch | KLASSIFIKATION DER ANMELDUNG (Int Cl⁴) |
|---|---|---|---|
| Y | GB - A - 2 220 951<br>(ISC CHEMICALS LIMITED)<br>  * Seite 1 - Seite 3, Zeile 2;<br>  Seite 4, Zeilen 13,22;<br>  Seite 5, Zeilen 1,2 *<br>-- | 1-10 | C 11 D 7/50<br>C 11 D 7/28<br>H 05 K 3/26 |
| Y | US - A - 3 987 111<br>(R. C. TERRELL)<br>  * Spalte 1, Zeilen 32-36;<br>  Spalte 2, Zeilen 53,54 *<br>-- | 1-10 | |
| D,Y | GB - A - 1 399 867<br>(IMPERIAL CHEMICAL INDUSTRIES LIMITED)<br>  * Seite 1, Zeilen 13-47;<br>  Seite 5 : Beispiel 2 *<br>-- | 1-10 | |
| Y | DE - A1 - 2 709 229<br>(W.R. GRACE & CO.)<br>  * Seite 5, Zeilen 9-17;<br>  Seite 12 : Beispiel 4 *<br>---- | 1-10 | RECHERCHIERTE SACHGEBIETE (Int. Cl⁴)<br><br>C 11 D<br>C 23 G<br>H 05 K |

Der vorliegende Recherchenbericht wurde für alle Patentansprüche erstellt.

| Recherchenort | Abschlußdatum der Recherche | Prüfer |
|---|---|---|
| WIEN | 10-07-1991 | REISER |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82